# EUROPEAN PATENT APPLICATION

(11) **EP 4 586 128 A1**
(43) Date of publication of application: **16.07.2025**
(21) Application number: 24219862.0
(22) Date of filing: 13.12.2024
(51) Int. Cl.: G06F 30/13, G06Q 50/08

(54) **A COMPUTER METHOD, DEVICE AND COMPUTER PRODUCT FOR GENERATING A BUILDING PRODUCT MODEL TO CALCULATE VARIOUS BUILDING ASPECTS**

(30) Priority: 15.01.2024 SE 2450037
(71) Applicant: Innovation Byggprocess Skåne AB, 211 49 Malmö (SE)
(72) Inventor: Campo Gay, Irene, 2900 Hellerup (DK)
(74) Representative: AWA Sweden AB

(57) **Abstract**

A computer implemented method for generating a building product model, the method comprising creating a set of object types, wherein each object type represents a distinct building element, and wherein each object type comprises a set of building element attributes, creating at least one core object type representing a building element, wherein the at least one core object type comprises a set of confining attributes, determining a value for at least one confining attribute in the set of confining attributes, determining values of a subset of building element attributes in the sets of building element attributes, wherein the determination is dependent on the at least one confining attribute, such that the values of a subset of building element attributes in the set of object types representing distinct building elements are confined by the at least one confining attribute.

## Description

### TECHNICAL FIELD

The present inventive concept relates, in general, to a building product model and, more particularly, to how to use the building product model for calculating various building related aspects such as bill of material, energy consumption, fire standard, and so on.

### BACKGROUND

Configuration systems can be viewed as technological tools designed to streamline the complex process of customizing products. Traditionally, these systems are seen as tools that facilitate the creation of customized products by leveraging a selection of predefined modules, interlinked by a series of constraints.

Manufacturing firms are increasingly adopting configuration systems in their quest to achieve cost, time, and quality parity between mass production and custom production. Yet, the Architecture, Engineering, Construction (AEC) industry is finding it difficult to shift from unique, one-off products to mass customization.

The AEC industry is characterized by having a fragmented value chain. Existing computerized calculation tools used by different stakeholders often operate independently, performing calculations and generating outputs without considering the broader project context Research on models with building parts is available in the art. However, the researched models are limited to prefabricated construction elements.

This lack of integration can lead to discrepancies, as the output from one tool may not align with the input requirements of another, resulting in inefficiencies and potential errors. The consolidation of outputs from these disparate tools into a coherent whole is a complex process, requiring significant computational resources.

For this reason, the AEC could benefit from adopting mass customization principles to achieve similar benefits to the ones obtained by manufacturing companies. In particular, the AEC industry could benefit from adopting computer models as a cooperation tool between actors such as suppliers, architects, contractors, and constructors to streamline and enhance house projects.

### SUMMARY

It is an objective of the present inventive concept to provide/enable a consolidated building product model. It is a further objective of the present inventive concept to facilitate calculation and generation of a bill of materials, cost calculations, environmental calculations and/or energy calculations. A further objective of the present inventive concept is to provide a computer model facilitating cooperation between stakeholders in a building project.

These and other objectives of the inventive concept are at least partly met by the invention as defined in the independent claims.

According to a first aspect there is provided a computer implemented method for generating a building product model, the method comprising creating a set of object types, wherein each object type represents a distinct building element, and wherein each object type comprises a set of building element attributes, creating at least one core object type representing a building element, wherein the at least one core object type comprises a set of confining attributes, determining a value for at least one confining attribute in the set of confining attributes, determining values of a subset of building element attributes in the sets of building element attributes, wherein the determination is dependent on the at least one confining attribute, such that the values of a subset of building element attributes in the set of object types representing distinct building elements are confined by the at least one confining attribute.

The inventor has realized that by setting at least one confining attribute that confines objects in the building product model, the calculations for generating e.g., a bill of material for a building, and/or the energy calculations for a building, are significantly optimized. By setting at least one confining attribute, the solution space of possible solutions when performing calculations for the construction of a building, can be confined. The computer implemented method facilitates a more streamlined calculation process and facilitates a more optimized computational efficiency, reducing the processing power required for complex calculations. The method facilitates a lower processing demand, leading to a significant decrease in processor workload.

The inventive concept significantly reduces the need for user intervention by automating and streamlining complex calculations. Due to the streamlined calculation process, facilitated by confining the solution space, the method reduces user interaction, allowing for more autonomous operation. An increased productivity is therefore enabled or facilitated by the inventive concept presented herein. The method enables or facilitates a shorter calculation time. Consequently, calculations that would previously take days or weeks may now be completed in minutes or hours. Usability is also enhanced since the method's efficient calculation mechanism reduces the frequency and complexity of user inputs required. By simplifying the calculation process, the method allows for increased operational efficiency. The inventive concept facilitates cooperation between e.g., suppliers, architects, contractors, and constructors, by streamlining and enhancing the calculations related to the construction of buildings.

The computer implemented method presented herein enables a consolidated building product model. A building aspect may be calculated by aggregating a set or a subset of instances of object types representing distinct building elements, wherein the set or subset may comprise the at least one core object type, wherein determining the building aspect is dependent on attributes of the set or subset of instances, the attributes being related to the building aspect.

The method does not depend on external software and/or implementation methods such as, for example, computer-aided design (CAD) software, and/or building information modeling (BIM) software. The computer implemented method for generating a building product model is therefore standalone and may be used independently. However, the method may advantageously be integrated with external software. Computer implemented interfaces and/or transferring of data between external software and data stored in the context of the computer-implemented method for generating a building product model, may advantageously be implemented to, for example, visualize, list, and/or optimize representations of building elements. Data may therefore be exported from and/or imported to the model.

In addition, the computer implemented method presented herein may be integrated into existing and/or already implemented software. The method can therefore be easily adapted to work with a variety of software systems, making it highly versatile. The method's ability to integrate with existing software means it can scale with the software as it grows and evolves, ensuring it remains effective in the long term.

Furthermore, the inventive concept presented herein enables or facilitates calculations of various building aspects. By confining the solution space, determining a value for at least one confining attribute in the set of confining attributes, calculations, such as generation of a bill of materials, cost calculations, environmental calculations and/or energy calculations, may be streamlined and/or simplified. This means that the range of possible values that variables of the model can take is narrowed down, thereby streamlining and/or simplifying calculations of various building aspects. For the execution of the calculations, objects may be aggregated, and subsets of building element attributes may be utilized as inputs to the calculations.

The generation of a bill of materials, cost calculations, environmental calculations and/or energy calculations are examples of calculations that often can be perceived as insurmountable challenges when dealing with a multitude of variables within an unconfined solution space. However, the confinement effectively reduces the dimensionality of the solution space, thereby streamlining the computational process and rendering complex calculations not only feasible but also computationally efficient.

Calculations related to on-site construction may serve as examples comprising unforeseen factors that can influence the solution space.

Nearly all buildings involve on-site construction. Functional requirements referring to energy, sound, loadbearing, stability etc., all relate to the complete building and its building elements, wherein the complete building involve on-site construction. Consequently, on-site construction must be considered for a complete calculation. The inventive concept presented herein facilitates or enables calculations comprising prefabricated construction elements and/or on-site construction elements.

Energy calculations may depend on e.g., attributes related to the building itself, but also requirements from, for example, authorities and/or stakeholders. The requirements may e.g., be related to location, energy, indoor temperature, power, water and ventilation.

As an example, the thermal transmittance for the building itself may be defined as a U-value. Thermal transmittance, also known as U-value, is the rate of transfer of heat through a structure (which can be a single material or a composite), divided by the difference in temperature across that structure. The better-insulated a structure is, the lower the U-value will be. The U-value of the building itself may be derived from the U-value and surface area of e.g., outer walls, roof/attic, underlying slab, windows and/or outer doors etc. The thermal transmittance may therefore e.g., be dependent on the build quality of the construction elements. Therefore, calculations regarding thermal transmittance may vary greatly between distinct construction projects. Consequently, disregarding on-site construction and performing calculations only on prefabricated building elements may render a skewed and/or incorrect result. The building elements constructed on site have to be considered to accurately perform energy calculations.

A computer model of a building may have a solution space wherein the number of possible may be perceived as infinite. However, by setting at least one confining attribute, the solution space of possible solutions when performing e.g., calculations for the construction of a building, can be confined. Calculations regarding e.g., energy, climate impact, load-bearing capacity, sound and/or fire properties may therefore be enabled or facilitated. The inventive concept presented herein enables or facilitates e.g., calculations comprising on-site and prefabricated construction elements.

As an example, the thermal transmittance calculation, as presented above, may be enabled or facilitated by the computer implemented method for generating a building product model. Attributes of a construction element may be stored in an object type of the present invention, such that, e.g., calculations regarding energy, climate impact, load-bearing capacity, sound and/or fire properties may be performed. The calculations being dependent on the aggregation of a set or a subset of instances of object types, as described herein.

By providing a computer implemented method for generating a building product model, creating at least one core object type representing a building element, determining a value for at least one confining attribute in the set of confining attributes, such that the values of a subset of building element attributes in the set of object types representing distinct building elements are confined by the at least one confining attribute, the solution space may be confined. The aggregation of instances of object types to perform calculations such as generation of a bill of materials, cost calculations, environmental calculations and/or energy calculations are therefore enabled and/or facilitated.

It should be understood that the present inventive concept allows for optimizations. Optimizations may e.g., include optimizing for several factors. For example, the factors can be optimized for the calculations mentioned herein. Examples of optimization factors may e.g., comprise building codes, customer requirements, environmental requirements, building permits, economic requirements, requirements from authorities, requirements from a municipality, fire safety, water safety, risk, acoustics, and/or material consumption.

According to examples of the inventive concept, the optimization factors can be implemented as constraining factors. Therefore, the present inventive concept allows for calculations to be optimized, wherein the calculations may be optimized based on at least one of the constraining factors.

According to a second aspect there is provided a device comprising a processor and a memory, the device being configured to perform the steps of a method according to the first aspect.

The device, comprising a processor and memory, is configured to perform the method according to the first aspect. This means that the device can generate a more consolidated model which facilitates calculations, such as calculations of a bill of materials, energy calculations, environmental calculations and/or cost calculations. This could lead to more efficient and accurate computations, potentially saving time and resources.

According to a third aspect there is provided a computer program having instructions which when executed by a data-processing system cause the data-processing system to perform a method according to the first aspect.

The computer program, when executed by a data-processing system, performs the method according to the first aspect. This means that the program can facilitate cooperation between stakeholders in a building project by providing a computer model. This could improve communication and collaboration, potentially leading to better project outcomes.

According to a fourth aspect there is provided a computer-readable non-transitory medium comprising instructions which, when executed by a computer, cause the computer to carry out the method of the first aspect.

This means that the medium can be used to store and transfer the method, allowing it to be used on different computers. This could increase the accessibility and portability of the method, potentially making it more widely available for use.

Further examples of the disclosure are defined in the dependent claims, wherein features for the fifth and subsequent aspects of the disclosure are as for the first to fourth aspects mutatis mutandis.

The at least one core object type may represent an exterior wall, wherein the set of confining attributes comprises confining attributes representing a length and a direction of the exterior wall.

For example, based on the length and the direction, determining an area of the building may comprise determining a Gauss area e.g., by utilizing a Shoelace Formula and/or any other known formulas and/or methods for calculating an area..

Determinations may e.g., be performed by a computer procedure, such as a routine, a subroutine, a method, a function, and/or specific code written in a programming language.

A building's exterior walls may represent a principal element in the building product model. By instantiating objects of the exterior wall type, and determining confining attributes representing a length and a direction, a realization of a house building shell may be facilitated.

The method may further comprise:
creating an object type representing a floor, wherein an instance of the object type representing a floor is interrelated with a set of instances of the object type representing an exterior wall.

The aggregation of objects representing an exterior wall, interrelated with an instance of an object type representing a floor, is therefore facilitated. This facilitates the determination of e.g., a load bearing and/or stability of an aggregated set or subset of objects representing the building's exterior walls, and/or a geometrical factor.

The method may further comprise creating a master object type representing a building, the master object comprising at least one geometrical attribute, determining a value of the at least one geometrical attribute, wherein the value of the at least one geometrical attribute is dependent upon the value of at least one building element attribute for each of a set of instances of a distinct object type.

The master object type may comprise attributes that could be considered common or shared in the building product model.

The master object type representing a building may serve to further consolidate the building product model.

The method may further comprise setting a constraining factor, such that at least one object type in the building product model comprises an attribute that is constrained by a constraining factor.

By setting a constraining factor, the solution space is further confined, resulting in an even further consolidated building product model, facilitating the generation of a bill of materials, energy calculations and cost calculations. A consolidated model also facilitates the collaboration between different stakeholders in a building project.

A further scope of applicability of the present disclosure will become apparent from the detailed description given below. However, it should be understood that the detailed description and specific examples, while indicating preferred variants of the present inventive concept, are given by way of illustration only, since various changes and modifications within the scope of the inventive concept will become apparent to those skilled in the art from this detailed description.

Hence, it is to be understood that this inventive concept is not limited to the particular steps of the methods described or component parts of the systems described as such method and system may vary. It is also to be understood that the terminology used herein is for purpose of describing particular examples only and is not intended to be limiting.

As used herein, the term "set" should be construed as a collection of distinct objects forming a group. A set can contain any number of elements, including none at all. A set can also contain a single element, or multiple elements.

As used herein, the term "subset" should be construed as a set where all elements of the subset are also elements of another set. A subset can be identical to the set from which it is derived.

As used herein, the term "building element" should be construed as a fundamental component or aspect of a building structure. It can be a tangible part like walls, floors, roofs, etc., or it can be an intangible aspect such as a design principle, architectural style, or functional purpose. These elements contribute to the overall form, function, and performance of the building.

As used herein, the term "interrelation" should be construed as a connection or relationship. The connection or relationship can be either direct or indirect. Unless otherwise specified, both direct and indirect connections are encompassed within this definition.

As used herein, the term "object" should be construed as an instance of a class in an object-oriented programming language. It is a software bundle of related state and behavior.

As used herein, the term "object type" should be construed as the data type of the object. It defines the values that can be taken by the object and the operations that can be performed on it. In object-oriented programming, it may be seen synonymous e.g., with class.

As used herein, the term "object instance", and/or the term "instance" in the context of an object, should be construed as a specific realization of an object. An object instance may be created from a class in object-oriented programming, e.g., by calling a constructor, a special type of subroutine designed to create the object.

As used herein, the term "core object type" should be construed as a fundamental object type that is foundational in a given context. A core object type may provide basic functionality and structure. It may represent a building element selected based on a particular model being designed, to best suit the specific requirements and constraints of the model.

As used herein, the term "attribute" should be construed as a specification that defines a property of an object, and/or an element. It may also refer to or set the specific value for a given instance of such. For objects, an attribute is a specification that defines a property of the object. Its value can be set or read during the object's lifetime, and it can be of any data type. It must be noted that, as used in the specification and the appended claim, the articles "a", "an", "the", and "said" are intended to mean that there are one or more of the elements unless the context clearly dictates otherwise. Thus, for example, reference to "a device" or "the device" may include several devices, and the like. Furthermore, the words "comprising", "including", "containing" and similar wordings do not exclude other elements or steps.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 is a flowchart of a method for generating a building product model.
Fig. 2 is a flowchart of a method for generating a building product model.
Fig. 3a is a flowchart of a method for generating a building product model.
Fig. 3b is a UML-diagram illustrating an example of an instance of an object type representing a floor being interrelated with a set of instances of the object type representing an exterior wall, FIG. 3b further comprises examples of attributes.
Fig. 4 is a flowchart of a method for generating a building product model.
Fig. 5 is a flowchart of a method for generating a building product model.
Fig. 6 is a UML-diagram exemplifying a basic setup of instances of objects, FIG. 6 further comprises examples of attributes.

### DETAILED DESCRIPTION

In cooperation with attached drawings, the technical contents and detailed description of the present invention are described thereinafter according to a preferable example, being not used to limit the claimed scope. This invention may be embodied in many different forms and should not be construed as limited to the examples set forth herein; rather, these examples are provided for thoroughness and completeness, and fully convey the scope of the invention to the skilled person.

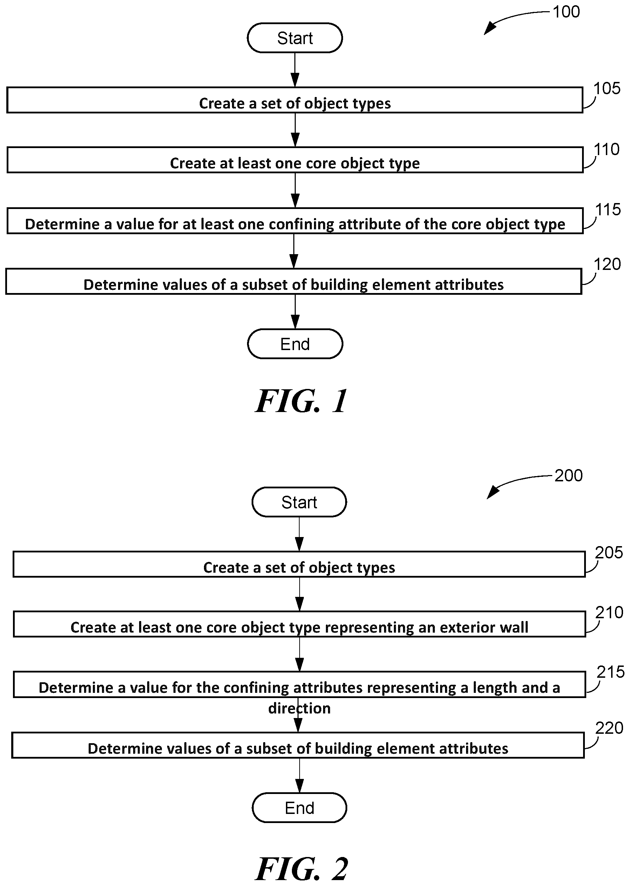

As shown in FIG. 1, a building product model is generated by a computer implemented method 100. The method comprises creating a set of object types 105, wherein each object type represents a distinct building element, and wherein each object type comprises a set of building element attributes. Creating at least one core object type 110 representing a building element, wherein the at least one core object type comprises a set of confining attributes. Determining a value for at least one confining attribute in the set of confining attributes 115. The method 100 further comprises determining values of a subset of building element attributes in the sets of building element attributes 120, wherein the determination is dependent on the at least one confining attribute, such that the values of a subset of building element attributes in the set of object types representing distinct building elements are confined by the at least one confining attribute.

In step 110 of FIG. 1, at least one core object type representing the building element is created. By creating at least one core object type representing the building element, wherein the at least one core object type comprises the set of confining attributes, a starting point for a consolidated model is provided. A more consolidated model facilitates calculations, such as calculations of a bill of materials, energy calculations and cost calculations. Instances of the at least one core object type, each comprising a set of confining attributes, may be aggregated and evaluated as a set, or individually. However, each confining attribute is a part of the confining of the solution space. The at least one core object type can advantageously represent a core construction element that is considered a principal element in the building product model. Examples of core construction elements may comprise: exterior wall, roof, inner wall, room, floor, frame or structural parts of the frame, foundation or structural parts of the foundation, gable, the building, etc.

Values of a subset of building element attributes of the set of object types representing distinct building elements are confined by the set of confining attributes. This implies that the building product model is further streamlined and consolidated. Examples of object types representing distinct building elements may comprise: opening, beam, gable, exterior wall, floor, the building, roof, section of roof, intersection of roof, roof window, inner wall, inner wall dry, inner wall wet, inner wall dry/wet, inner wall bearing, inner wall fire resistant, inner door, inner door dry, inner door wet, room, kitchen, bathroom, laundry, living room, dining room, hall, bedroom, closet, etc.

Determining a value for at least one confining attribute in the set of confining attributes is illustrated e.g., in step 115 of FIG. 1.

As an example, the value of the at least one confining attribute in the set of confining attributes may be determined such that the value of a building element attribute representing the dimensions of an inner door is confined by the at least one confining attribute.

As another example, the value of the at least one confining attribute in the set of confining attributes may be determined such that the value of a building element attribute representing the strength of a load-bearing beam is confined by the at least one confining attribute.

Furthermore, the at least one confining attribute in the set of confining attributes may confine values of building element attributes indirectly. As an example, the dimensions of an inner door being confined by the at least one confining attribute may confine the value of the attribute representing the dimensions of a door opening. In this example, the at least one confining attribute indirectly confines the value of the attribute representing the dimensions of a door opening.

The at least one core object type, created e.g., in step 110 of FIG. 1, comprises a set of confining attributes, such that, for example, values of subsets of building element attributes of a set of object types, or multiple sets of object types, representing distinct building elements are confined by the set of confining attributes.

The at least one core object type may be a plurality of core object types, wherein each object type represents a distinct building element, and wherein each object type comprises a set of confining attributes, such that, for example, values of subsets of building element attributes of a set of object types, or multiple sets of object types, representing distinct building elements are confined by the set of confining attributes in the plurality of core object types.

Determining values of a subset of building element attributes in the sets of building element attributes is illustrated e.g., in step 120 of FIG. 1. The determination is dependent on the at least one confining attribute. The values of the subset of building elements may for example be determined by a computer procedure, such as a routine, a subroutine, a method, a function, and/or specific code written in a programming language. The computer procedure may accept the at least one confining attribute as an argument, a parameter and/or a constant, and perform computations to determine the values of the subset of building element attributes, wherein the at least one confining attribute serves as a factor for confining the values of the subset of building element attributes.

A second example (200), shown in FIG. 2, comprises the following steps; a set of object types is created (200), at least one core object type representing an exterior wall (210) is created, a value for the confining attributes representing a length and a direction is determined (215), values of a subset of building element attributes are determined (220).

Consequently, the at least one core object type may represent an exterior wall, wherein the set of confining attributes comprises confining attributes representing a length and a direction of the exterior wall.

A building's exterior walls may represent a principal element in the building product model. By instantiating objects of the exterior wall type, and determining confining attributes representing a length and a direction, a realization of a house building shell may be facilitated.

The direction may be a direction of the exterior wall in a floorplan according to a cartesian coordinate system, and the length may be a length of a wall as defined in the floorplan. Aggregating a set or a subset of the objects representing a building's exterior walls facilitates determination of geometrical factors, such as e.g., a building perimeter, a building area, inner corners of a building, and/or outer corners of a building.

For example, based on the length and the direction, determining an area of the building may comprise determining a Gauss area e.g., by utilizing a Shoelace Formula and/or any other known formulas and/or methods for calculating an area..

Determinations may e.g., be performed by a computer procedure, such as a routine, a subroutine, a method, a function, and/or specific code written in a programming language.

The geometrical factors mentioned above, derived from the set of confining attributes, may facilitate a further realization of the house building shell. Determining values of a subset of building element attributes in the sets of building element attributes, may include taking into account the geometrical factors. As an example, in the set of object types, wherein each object type represents a distinct building element, an object type may e.g., be representing a room. A building element attribute of the object type representing a room may for example represent a dimension of the room. Determining a value of the building element attribute representing the dimension of the room, may take into account at least one of the geometrical factors, such that the represented dimensions of the room are confined by at least one of the geometrical factors.

The set of attributes of the core object type representing an exterior wall may further comprise an attribute representing a load bearing and/or stability of the exterior wall. The determination of the load bearing and/or stability of the exterior wall may be dependent for example on the length of the exterior wall. The determination of the load bearing and/or stability of the exterior wall in this example, may consequently be confined by the attribute representing a length of the exterior wall. The load bearing and/or stability of the exterior wall may be dependent upon other factors, such as the type and/or thickness of the material used to construct the wall.

Aggregating a set or a subset of the objects representing the building's exterior walls may therefore facilitate determination of the aggregated load bearing and/or stability for the set or the subset of the objects representing the building's exterior walls. Determining a load bearing and/or stability for a building or a section of a building may consequently comprise aggregating objects representing distinct sets and/or subsets of objects associated with the building product model and/or a distinct section of the building product model, such that the aggregated load bearing and/or stability for the building and/or the section of the building may be determined.

As an example, in the set of object types, wherein each object type represents a distinct building element, an object type may e.g., be representing an opening. An attribute of the object type representing an opening may for example represent a dimension of the opening. Determining a value of the attribute representing the dimension of the opening, may take into account the attribute representing a load bearing and/or stability of the exterior wall, such that the represented dimensions of the opening are confined by the attribute representing a load bearing and/or stability of the exterior wall.

The method may further comprise creating an object type representing a floor, wherein an instance of the object type representing a floor is interrelated with a set of instances of the object type representing an exterior wall.

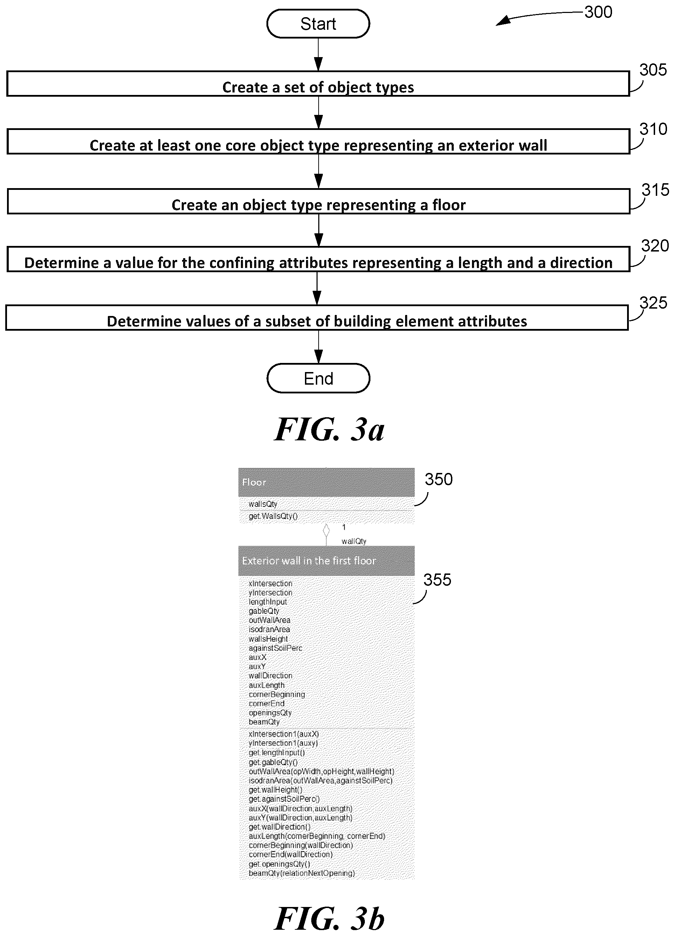

FIG. 3a illustrates a third example (300) comprising creating a set of object types (305), creating at least one object type representing an exterior wall (310), creating an object type representing a floor (315), determining a value for the confining attributes representing a length and a direction (320), determining values of a subset of building element attributes (325).

The aggregation of objects representing an exterior wall, interrelated with an instance of an object type representing a floor, is therefore facilitated.

FIG. 3b illustrates an example of an instance of an object type representing a floor (350) being interrelated with a set of instances of the object type representing an exterior wall (355), FIG. 3b further comprises examples of attributes. FIG. 3b provides a representation of a setup between two object instances of the model, it is to be understood that the actual implementation may vary, and the depiction in FIG. 3b should not be interpreted as limiting the scope of the invention. It is to be appreciated that modifications, additions, or deletions may be made without departing from the scope of the inventive concept as described herein.

The object type representing a floor may further comprise an attribute representing a quantity of exterior walls, such that a value of the attribute representing a quantity of exterior walls in an instance of the object type representing a floor represents the quantity of instances of the object type representing an exterior wall that is interrelated with the instance of the object type representing a floor.

The aggregation of objects representing an exterior wall, interrelated with an instance of an object type representing a floor, may further facilitate the determination of e.g., a load bearing and/or stability of an aggregated set or subset of objects representing the building's exterior walls, as mentioned above, or a geometrical factor, also mentioned above.

As an example, an instance of the object type representing a floor may be interrelated with a set of instances of objects representing an exterior wall. Each of the instances of the set of objects representing an exterior wall may be interrelated with a set of instances of objects representing an opening and/or with a set of instances of objects representing a beam. Determination of the quantity of openings indirectly related to an instance of object type representing a floor, and/or the load bearing and/or stability related to an instance of the object type representing a floor may therefore be facilitated.

As another example, an instance of the object type representing a floor may be interrelated with a set of instances of objects representing an exterior wall. A determination of a dimension related to the floor may therefore be facilitated. For example, a determination of an area of the floor may be facilitated. The area of the floor may e.g., be inner area of the floor and/or a section of the floor. Determination of a material used for the floor may therefore be facilitated. The determination of the material used for the floor may account for e.g., attributes of a distinct material and/or attributes set by e.g., a supplier of a distinct material.

As an example, the supplier of the distinct material may supply a distinct material e.g., of a certain length and/or a certain package size. The inventive concept presented herein may facilitate the determination of materials used for the floor, wherein e.g., a dimension such as the area and attributes of a distinct material and/or attributes set by e.g., a supplier of a distinct material may be accounted for in the determination. Consequently, the determination of material used for the floor enables a realization regarding material consumption.

The above is an example of a calculation of a building aspect. The inventive concept presented herein enables or facilitates calculations of various building aspects related to any set or subset of objects of the building project model. Therefore, the inventive concept presented herein facilitates or enables calculations of various building aspects. As stated before, a building aspect may be calculated by aggregating a set or a subset of instances of object types representing distinct building elements, wherein the set or subset may comprise the at least one core object type, wherein determining the building aspect is dependent on attributes of the set or subset of instances, the attributes being related to the building aspect. For building aspects related to material, wherein a realization regarding material consumption is enabled, as mentioned above, the present inventive concept may enable or facilitate accuracy regarding material consumption. Consequently, less unused building material and less waste may be enabled by the inventive concept presented herein. This may for example enable a more environmentally friendly construction project.

An instance of the object type representing a floor may further be interrelated with a set of instances of object types representing a building gable, wherein each object type representing a building gable comprises a building element attribute representing a building gable dimension, and wherein determining a living area is dependent on the building element attribute representing a building gable dimension.

In accordance with certain standards, the computation of the area beneath a pitched roof does not universally designate all of the encompassed space as habitable living area. For example, if the angle of the roof is steep, the space directly under it may be too narrow to be considered habitable, thus reducing the total living area. Therefore, determining living area may comprise excluding some of the wall-to-wall area in a building with gables.

An object type representing a building gable dimension may represent e.g., a gable perimeter, an angle, an area, a length, a volume, etc.

Determining a living area of a certain floor, wherein the object type representing a floor is interrelated with a set of instances of object types representing a building gable and a set of instances of the object type representing an exterior wall, may comprise aggregating the interrelated objects, taking into account e.g., a building element attribute representing an angle, such that determining a living area is dependent on the building element attribute representing a building gable angle.

What is considered habitable living area in accordance with the certain standards, may be determined by standards for various aspects of a building. For example, a building may comprise a storage room and/or a garage, wherein the storage room and/or garage is not considered habitable living area in accordance with the certain standards. The present inventive concept may facilitate a determination of habitable living area by enabling or facilitating the aggregation of distinct sets of objects associated with a distinct section of the building product model. Consequently, the determination of habitable living area may e.g., exclude an area of e.g., the storage room and/or the garage.

An object type in the set of object types may represent a building gable, wherein determining a value of a building element attribute representing a building gable area is dependent on the at least one confining attribute representing a length of the exterior wall.

Consequently, the at least one confining attribute representing a length of the exterior wall confines a determination of value of a building element attribute representing a building gable area, directly or indirectly.

A length of a building gable may for example differ from e.g., the length of the exterior wall, however, in determining a building area gable, wherein factors like type of gable, material of the gable, and strength of the exterior wall might be taken into consideration, the at least one confining attribute representing a length of the exterior wall serves to confine at least one of the factors comprised in the determination of the building element attribute representing a building gable area, such that the at least one confining attribute representing a length of the exterior wall confines the building element attribute representing a building gable area, directly or indirectly.

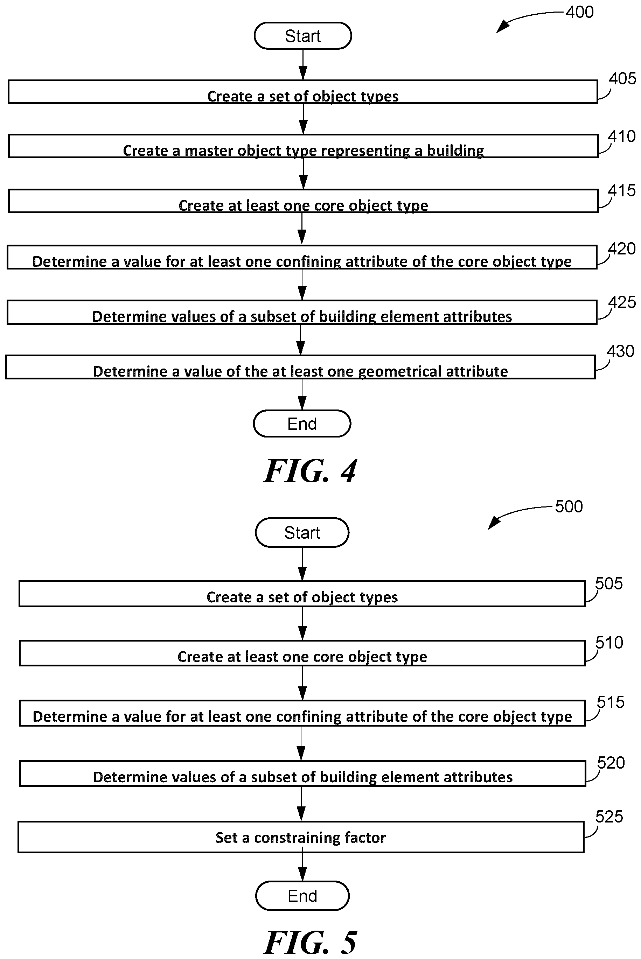

A fourth example (400), is illustrated in FIG. 4. This example comprises creating a set of object types (405), creating a master object type representing a building (410), creating at least one object type (415), determining a value for at least one confining attribute of the core object type (420), determining values of a subset of building element attributes (425), determining a value of the at least one geometrical attribute (430).

Consequently, the method may further comprise creating a master object type representing a building (410), the master object comprising at least one geometrical attribute, determining a value of the at least one geometrical attribute (430), wherein the value of the at least one geometrical attribute is dependent upon the value of at least one building element attribute for each of a set of instances of a distinct object type.

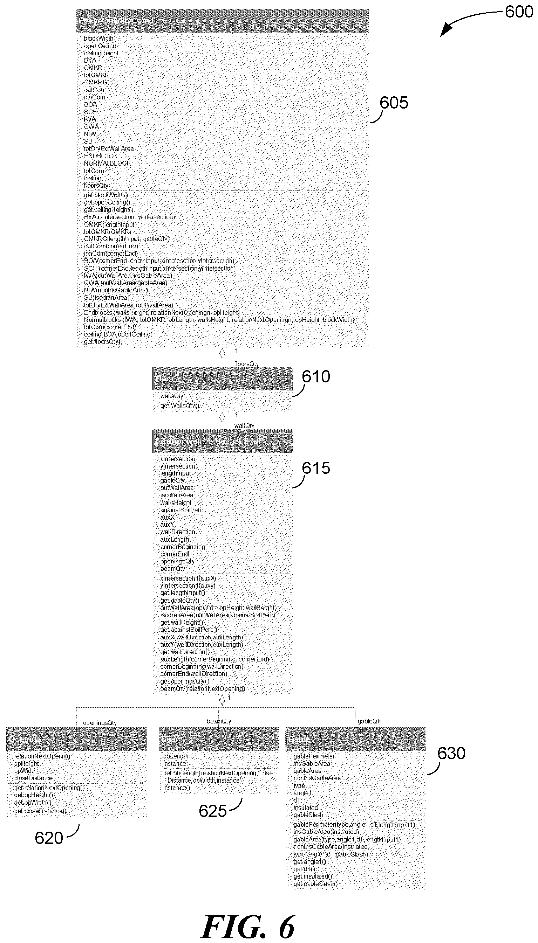

The UML-diagram of FIG. 6 exemplifying a basic setup of instances of objects, with "one-to-many" relationships (in UML, Unified Modeling Language, notation) between objects. The master object representing a building is illustrated by 605 in FIG. 6. FIG. 6 further comprises examples of attributes. The illustration of FIG. 6 is provided as a non-limiting basic example of a setup. It should be understood that the configuration and arrangement of object instances as depicted in FIG. 6 are merely illustrative, and variations in the specific layout, positioning, and number of objects may occur. The setup as shown in FIG. 6 is not intended to limit or restrict the scope of the present invention in any way. Rather, it is to be appreciated that modifications, additions, or deletions to the model may be made without departing from the scope of the inventive concept as described herein. Such modifications may include, but are not limited to, the addition or removal of objects, alteration of object properties, or changes in the arrangement of objects..

Therefore, while FIG. 6 provides a basic representation of a setup (600), it is to be understood that the actual implementation may vary, and the depiction in FIG. 6 should not be interpreted as limiting the scope of the invention.

The master object type representing a building may e.g., represent the house building shell. An instance of the master object type (605) representing a building may e.g., be interrelated with a set of instances of objects representing a floor (610), wherein each set of instances of objects representing a floor (610) is interrelated with a set of instances representing an exterior wall (615), wherein each set of instances representing an exterior wall (615) has further interrelations with a set of instances of object types wherein each object type represents a distinct building element. In the setup illustrated in FIG. 6, the one or more instances of the exterior wall object type (615) is interrelated with one or more instances of each of an opening object type (620), a beam object type (625), and a gable object type (630). The instance of the master object type representing a building (605), the set of instances of objects representing a floor (610), and the set of instances of object types wherein each object type represents a distinct building element may each e.g., be further interrelated with a set of instances of object types wherein each object type represents a distinct building element.

Consequently, the master object type representing a building may serve to further consolidate the building product model.

The determination of the value of the at least one geometrical attribute of the master object type may comprise e.g., aggregating a subset of instances of a set of instances of a distinct object type, wherein the set of instances of a distinct object type may comprise the at least one core object type. The determination of the value of the at least one geometrical attribute of the master object, being dependent on the value of at least one building element attribute for each of a set of instances of a distinct object type, may consequently comprise determining the value of the at least one geometrical attribute dependent on a set of attributes comprising building element attributes and/or at least one confining attribute.

The at least one geometrical attribute may represent a building area, wherein the set of confining attributes of the at least one core object type comprises confining attributes representing the X and Y coordinates of the initial corner of an exterior wall, such that the determination of the at least one geometrical attribute, representing a building area, is dependent on the confining attributes representing the X and Y coordinates of the initial corner of an exterior wall, for each of a set of instances of the at least one core object type.

The master object type may comprise attributes that could be considered common or shared in the building product model. An example of such a common or shared attribute may be the at least one geometrical attribute representing a building area.

Determining the building area may comprise aggregating instances of the at least one core object type, wherein the at least one core object type comprises confining attributes representing the X and Y coordinates of the initial corner of an exterior wall. As stated before, based on the length and the direction, determining an area of the building may comprise determining the Gauss area e.g., by utilizing the Shoelace Formula and/or any other known formulas and/or methods for calculating an area.

The master object type may further comprise an attribute representing a living area, wherein the determination of the value of the attribute representing a living area comprises the determination of a representation of a living area of a certain floor, wherein a certain floor is represented by an instance of an object type representing a floor, or the object type representing a floor.

Consequently, the determination of the value of the attribute representing a living area may comprise determining a living area of a certain floor as described above.

As stated above, the master object type representing a building may further consolidate the building product model. The interrelation of objects, wherein the master object type may be interrelated with a set of instances representing distinct building elements, wherein the set of subset may comprise the at least one core object type. Consequently, the aggregation of objects in the building product model may be further facilitated, such that calculations of building aspect, as mentioned herein, may be further facilitated.

The determination of a living area of a certain floor may comprise determining the interrelations between an instance of an object type representing a floor, or the object type representing a floor, and a set of instances of an object type representing an exterior wall, or the object type representing an exterior wall.

The determining a living area of a certain floor may, e.g., for instances of objects representing a floor that is not directly interrelated with a set of instances of objects representing a building gable, be determined wherein the determination comprises aggregating the interrelated objects, taking into account e.g., a set of confining attributes representing a length and a direction of an exterior wall.

The master object type may further comprise common or shared attributes representing e.g., a set or a subset of: width of the blocks used to build the exterior walls, percentage of ceiling of a house that is open to the roof of the house, interior height of the floor (between floor and ceiling), building area, perimeter of the floor, total perimeter, perimeter of the building without considering walls with gables, outer corners, inner corners, living area of a floor, volume of the shaft of the house building, insulated exterior walls area including insulated gables and excluding openings, insulated exterior walls area including all gables and excluding openings, non-insulated gables area, end block, normal block, total corners, ceiling area excluding area open to the roof, quantity of floors, etc.

The method therefore generates a consolidated building product model. As stated before, a consolidated model facilitates calculations, such as calculations of a bill of materials, energy calculations and cost calculations.

As stated above, the master object type may comprise the set or subset of common or shared attributes as exemplified above, however, it should be noted that the determinations of the above attributes are within the scope of the building product model, such that the determinations of the above attributes are not necessarily dependent on the master object type.

As illustrated in FIG. 5, the method may further comprise setting a constraining factor (525), such that at least one object type in the building product model comprises an attribute that is constrained by a constraining factor.

Example 500 is illustrated in FIG. 5. This example comprises creating a set of object types (505), creating at least one core object type (510), determining a value for at least one confining attribute of the core object type (515), determining values of a subset of building element attributes (520), setting a constraining factor (525).

By setting a constraining factor (525), the solution space is further confined, resulting in an even further consolidated building product model, facilitating the generation of a bill of materials, energy calculations and cost calculations. A consolidated model also facilitates the collaboration between different stakeholders in a building project.

The constraining factor may be related to at least one of building codes, customer requirements, environmental requirements, building permits, economic requirements, requirements from authorities, requirements from a municipality, fire safety, water safety, risk, acoustics, material consumption.

Advantages of setting a constraining factor comprises that it may enable the safeguarding regarding a construction project being sustainable and have a minimal negative impact on the environment. It may further be advantageous as it may enable insight regarding the safety of the future occupants of the building, the construction workers, and the surrounding public. Adhering to building codes, fire safety regulations, and water safety guidelines, among other things, can help to avoid accidents and dangerous situations. Many constraints are legally required. By incorporating constraints into construction calculations from the start, the project may for example be in compliance with the law, and potential legal troubles may be avoided. Constraints related to customer requirements may ensure that the final building meets the needs and expectations of the people who will be using it. Constraints related to economic requirements may help to ensure that the project is financially feasible. This can include constraints related to the budget, the timeline, and the projected return on investment. Requirements from a municipality or other authorities can often reflect the needs and desires of the larger community. Constraints related to municipality and/or authority requirements may help to ensure that a project is accepted and welcomed by the people who live and work in the surrounding area. Imposing constraints regarding risk can help to anticipate potential problems and mitigate them before they become serious issues. This can include everything from the risk of natural disasters to the risk of cost overruns or delays. Imposing constraints may lead to improved planning and design. Constraints may provide quality assurance. If a construction project adheres to codes and requirements, it may be assumed that the quality of work will be high. Buildings that are designed and constructed with constraints often have a higher long-term value. They are safer, more efficient, and more likely to meet the needs of future occupants.

A building element attribute of an object type may represent a width of the blocks used to build the exterior walls, wherein a constraining factor defines at least one extremum value, such that the represented dimension of the blocks used to build the exterior walls is constrained to not exceed the at least one extremum value.

As an example, a minimum value for a thickness of a wall may be provided for meeting requirements regarding fire safety. The constraining factor may be related to fire safety, such that the represented dimension of the blocks used to build the exterior walls is constrained to not exceed the at least one extremum value, wherein the extremum value is a minimum value.

In addition, a building element attribute of an object type may represent a load bearing and/or stability of a wall, wherein a constraining factor defines at least one extremum value, such that the represented load bearing and/or stability of a wall is constrained to not exceed the at least one extremum value.

For example, a minimum value for a load bearing and/or stability of a wall may be provided for meeting requirements regarding building codes, building permits, requirements from authorities, requirements from a municipality, and/or risk. The constraining factor may be related to building codes, building permits, requirements from authorities, requirements from a municipality, and/or risk, such that the represented load bearing and/or stability of a wall is constrained to not exceed the at least one extremum value, wherein the extremum value is a minimum value.

Furthermore, a building element attribute of an object type may represent an environmental impact of the building element, wherein a constraining factor defines at least one extremum value, such that the represented environmental impact of the building element is constrained to not exceed the at least one extremum value.

For example, a maximum value for an environmental impact of the building element may be provided for meeting requirements regarding building codes, building permits, requirements from authorities, requirements from a municipality, customer requirements, environmental requirements, and/or requirements from a municipality. The constraining factor may be related to building codes, building permits, requirements from authorities, requirements from a municipality, customer requirements, environmental requirements, and/or requirements from a municipality, such that the represented load bearing and/or stability of a wall is constrained to not exceed the at least one extremum value, wherein the extremum value is a maximum value.

A building element attribute of an object type may also represent a cost of the building element, wherein a constraining factor defines at least one extremum value, such that the represented cost the building element is constrained to not exceed the at least one extremum value.

A constraining factor may further be set to optimize for accuracy regarding material consumption.

Optimizing for accuracy regarding material consumption means that the model facilitates the calculations of an accurate bill of materials. This means that the bill of materials comprises a more exact amount of material needed to construct a building. When calculating a bill of materials, it is common in the industry to calculate for a higher material consumption than actually needed, to take into account e.g., miscalculations and other errors. This may lead to waste and may be costly and have a negative impact on the environment. Optimizing for accuracy regarding material consumption may therefore lead to a more economically and environmentally sustainable project.

According to an example, there is provided a device comprising a processing unit and a memory, the device being configured to perform the steps of the method according to the method presented herein.

The processing unit may be implemented as a general-purpose processing unit, such as a central processing unit (CPU), which may execute the instructions of one or more computer programs in order to implement the method. The processing unit may alternatively be implemented as firmware arranged in an embedded system, or as a specifically designed processing unit, such as an Application-Specific Integrated Circuit (ASIC) or a Field-Programmable Gate Array (FPGA), which may be configured to implement the method.

The processing unit may be arranged internally in the device. Alternatively, the processing unit may be arranged in an external unit, or it may be processing unit of an external computer not being part of a common physical housing holding the device. Data may be transferred to the processing unit, either by a wired connection or wirelessly. As yet another alternative, the processing unit may be distributed among physical units, such that parts of the processing may be performed in different physical units.

The memory may be implemented as a general-purpose memory unit, such as a Random Access Memory (RAM) or a Read-Only Memory (ROM), which may store the data and instructions for the processing unit to execute. The memory could also be implemented as firmware arranged in an embedded system, or as a specifically designed memory unit, such as a flash memory or a solid-state drive (SSD), which may be configured to store the data.

The memory may be arranged internally in the device. Alternatively, the memory may be arranged in an external unit, or it may be a memory unit of an external computer not being part of a common physical housing holding the device. Data may be transferred to the memory, either by a wired connection or wirelessly. As yet another alternative, the memory may be distributed among physical units, such that parts of the data storage may be performed in different physical units. This allows for flexibility in the design and implementation of the device, enabling it to adapt to various use cases and environments.

According to an example, there is provided a computer program having instructions which when executed by a data-processing system cause the data-processing system to perform the method presented herein.

The computer program may be a standalone program or a module within a larger software ecosystem. It can be written in any suitable programming language and can be executed on various types of computing systems, including but not limited to personal computers, servers, mobile devices, embedded systems, and cloud-based virtual machines.

The computer program may be stored on a physical storage medium, such as a hard disk drive or a solid-state drive, or it may be hosted on a network server and accessed over the internet. The instructions of the software application can be loaded into the memory of the computing system and executed by the processing unit of the system.

According to an example, there is provided computer-readable non-transitory medium comprising instructions which, when executed by a computer, cause the computer to carry out the method 100 as described above.

The computer-readable non-transitory medium can be any form of storage device that can retain data for a period of time, even when power is not supplied. Examples include, but are not limited to, hard disk drives, solid-state drives, USB flash drives, memory cards, ROM, and optical discs like CD, DVD, and Blu-ray.

The instructions may be read and executed by the processing unit of the computer. This allows the computer to carry out the method as described herein.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A computer implemented method for generating a building product model to calculate various building aspects, the method comprising:
creating a set of object types, wherein each object type represents a distinct building element, and wherein each object type comprises a set of building element attributes,
creating at least one core object type representing a building element, wherein the at least one core object type comprises a set of confining attributes,
determining a value for at least one confining attribute in the set of confining attributes,
determining values of a subset of building element attributes in the sets of building element attributes, wherein the determination is dependent on the at least one confining attribute, such that the values of a subset of building element attributes in the set of object types representing distinct building elements are confined by the at least one confining attribute.

2. The method according to claim 1, wherein the at least one core object type represents an exterior wall, and wherein the set of confining attributes comprises confining attributes representing a length and a direction of the exterior wall.

3. The method according to claim 2, further comprising:
creating an object type representing a floor, wherein an instance of the object type representing a floor is interrelated with a set of instances of the object type representing an exterior wall.

4. The method according to claim 3, wherein an instance of the object type representing a floor is further interrelated with a set of instances of object types representing a building gable, and wherein each object type representing a building gable comprises a building element attribute representing a building gable dimension, and wherein determining a living area is dependent on the building element attribute representing a building gable dimension.

5. The method according to claim 2, 3 or 4, wherein an object type in the set of object types represents a building gable, and wherein determining a value of a building element attribute representing a building gable area is dependent on the at least one confining attribute representing a length of the exterior wall.

6. The method according to any one of the preceding claims, further comprising:
creating a master object type representing a building, the master object comprising at least one geometrical attribute,
determining a value of the at least one geometrical attribute, wherein the value of the at least one geometrical attribute is dependent upon the value of at least one building element attribute for each of a set of instances of a distinct object type.

7. The method according to claim 6, wherein the at least one geometrical attribute represents a building area, and wherein the set of confining attributes of the at least one core object type comprises confining attributes representing the X and Y coordinates of the initial corner of an exterior wall, such that the determination of the at least one geometrical attribute, representing a building area, is dependent on the confining attributes representing the X and Y coordinates of the initial corner of an exterior wall, for each of a set of instances of the at least one core object type.

8. The method according to claim 6 or 7, wherein the master object type further comprises an attribute representing a living area,
wherein the determination of the value of the attribute representing a living area comprises the determination of a representation of a living area of a certain floor, wherein a certain floor is represented by an instance of an object type representing a floor, or the object type representing a floor according to claim 3.

9. The method according to claim 8, wherein the determination of a living area of a certain floor comprise determining the interrelations between an instance of an object type representing a floor, or the object type representing a floor according to claim 3, and a set of instances of an object type representing an exterior wall, or the object type representing an exterior wall according to claim 2.

10. The method according to any one of the preceding claims, further comprising:
setting a constraining factor, such that at least one object type in the building product model comprises an attribute that is constrained by a constraining factor.

11. The method according to claim 10, wherein a building element attribute of an object type represents a width of the blocks used to build the exterior walls, and wherein a constraining factor defines at least one extremum value, such that the represented dimension of the blocks used to build the exterior walls is constrained to not exceed the at least one extremum value.

12. The method according to claim 10 or 11, wherein the constraining factor is related to at least one of building codes, customer requirements, environmental requirements, building permits, economic requirements, requirements from authorities, requirements from a municipality, fire safety, water safety, risk, acoustics.

13. A device comprising a processor and a memory, the device being configured to perform the steps of the method according to any one of claims 1 to 12.

14. A computer program having instructions which when executed by a data-processing system cause the data-processing system to perform the method according to any one of claims 1 to 12.

15. A computer-readable non-transitory medium comprising instructions which, when executed by a computer, cause the computer to carry out the method of any one of claims 1 to 12.
